# EUROPEAN PATENT APPLICATION

(11) **EP 4 753 387 A1**
(43) Date of publication of application: **03.06.2026**
(21) Application number: 24844466.3
(22) Date of filing: 18.06.2024
(51) Int. Cl.: H05K 7/20, H01L 23/367

(54) **POWER APPARATUS AND ELECTRONIC SPEED CONTROL MODULE THEREOF**

(30) Priority: 27.07.2023 CN 202310934744; 24.05.2024 CN 202410652588
(71) Applicant: Autoflight (Kunshan) Co., Ltd., Suzhou, Jiangsu 215345 (CN)
(72) Inventor: TIAN, Yu, Suzhou, Jiangsu 215345 (CN); CAO, Yifei, Suzhou, Jiangsu 215345 (CN)
(74) Representative: MERH-IP Matias Erny Reichl Hoffmann Patentanwälte PartG mbB
(86) International application number: PCT/CN2024/099700
(87) International publication number: WO 2025/020771

(57) **Abstract**

The present invention relates to the field of power technology and discloses a power unit and its electronic speed controller (ESC) module. The ESC module in the present invention comprises a PCB, a plurality of transistors arranged at intervals along an edge of the PCB, and a module housing fitted over the PCB, wherein the side of each transistor facing the module housing is connected to a ceramic substrate, and the ceramic substrate establishes thermal conduction with an inner wall of the module housing to dissipate heat generated by the transistors. The present invention utilizes a ceramic substrate to transfer heat generated by power devices to the exterior of the module housing, achieving high heat dissipation efficiency while ensuring electrical insulation between the power devices and the module housing.

## Description

### FIELD OF THE DISCLOSURE

The present invention relates to the field of power technology, and particularly relates to a power unit and its electronic speed controller (ESC) module.

### BACKGROUND OF THE INVENTION

Currently, most new energy vehicles on the market employ IGBT (Insulated Gate Bipolar Transistor) or other MOSFET (Metal-Oxide-Semiconductor Field-Effect Transistor) power components, which feature concentrated heat dissipation surfaces. For motor controllers with air-cooled structures, concentrated heat dissipation is a disadvantage. Motor controllers for electric aircraft can utilize the airflow during flight for air-cooling, whereas liquid-cooling adds the extra weight of coolant. Therefore, air-cooling is more commonly adopted based on lightweight design requirements. Utilizing a decentralized heat dissipation mode can provide a larger heat dissipation area, thereby improving cooling efficiency, while simultaneously accounting for the insulation requirements of high-voltage components.

### SUMMARY OF THE INVENTION

The objective of the present invention is to provide a power unit and its electronic speed controller (ESC) module. The present invention utilizes a ceramic substrate to transfer the heat generated by power devices to the exterior of the housing, achieving high heat dissipation efficiency while ensuring electrical insulation between the power devices and the housing.

To solve the above technical problem, the present invention provides an electronic speed controller module, comprising: a PCB; a plurality of transistors arranged at intervals along an edge of the PCB; a module housing fitted over the PCB, wherein a side of each transistor facing the module housing is connected to a ceramic substrate, and the ceramic substrate establishes thermal conduction with an inner wall of the module housing to dissipate heat generated by the transistors.

Further, the present invention provides a power unit, comprising a motor module and the ESC module.

Preferably, a thermal grease is applied between the ceramic substrate and the inner wall of the module housing.

Preferably, the transistors are placed vertically on the edge of the PCB and heat dissipation surfaces of the transistors are perpendicular to the plane of the PCB.

Preferably, the ceramic substrate is partially coated with a copper foil, and heat dissipation surfaces of the transistors are soldered to the copper-coated portions of the ceramic substrate.

Preferably, the PCB has a regular hexagonal structure, and the transistors are arranged in central symmetry with the center of the PCB as the origin.

Preferably, the ESC module further comprises a plurality of heat sinks, the module housing has a regular hexagonal structure and encloses the PCB, an outer side of the module housing is surrounded by the plurality of heat sinks, and the outer edges of the plurality of heat sinks form a circular structure.

Preferably, a thickness of the ceramic substrate is at least 0.9 mm.

Preferably, the transistors are Silicon Carbide (SiC) MOSFETs.

Preferably, each transistor comprises a pair of high-voltage pins, the edge of the PCB is provided with a plurality of gaps each forming an air slot, and each pair of high-voltage pins is soldered to both sides of a gap.

The present invention utilizes a ceramic substrate to transfer the heat generated by power devices to the exterior of the housing, achieving high heat dissipation efficiency while ensuring electrical insulation between the power devices and the housing.

### BRIEF DESCRIPTION OF DRAWINGS

FIG. 1 shows a structural schematic diagram of an electronic speed controller module according to an embodiment of the present invention.
FIG. 2 shows a structural schematic diagram of the PCB of the electronic speed controller module according to an embodiment of the present invention.

### DETAILED DESCRIPTION

The following embodiments further illustrate the technical solutions of the present invention. It can be understood that the specific embodiments described herein are only used to explain the present invention. Additionally, it should be noted that, for ease of description, the drawings only show parts related to the present invention and not all parts.

In the description of the present invention, unless otherwise specified, terms such as "install", "connect", and "attach" should be interpreted broadly. For example, connections may be fixed or detachable, mechanical or electrical, direct or indirect via intermediate components, or internal connections between two elements. Those skilled in the art can understand the specific meanings of these terms in the present invention based on the context.

In the present invention, unless otherwise specified and defined, the first feature being "on" or "under" the second feature may include the first and second features being in direct contact, or may include the first and second features not being in direct contact but being in contact through additional features between them. Moreover, the first feature being "on", "above", or "over" the second feature includes the first feature being directly above or obliquely above the second feature, or merely indicates that the horizontal height of the first feature is higher than that of the second feature. The first feature being "under", "below", or "beneath" the second feature includes the first feature being directly below or obliquely below the second feature, or merely indicates that the horizontal height of the first feature is lower than that of the second feature.

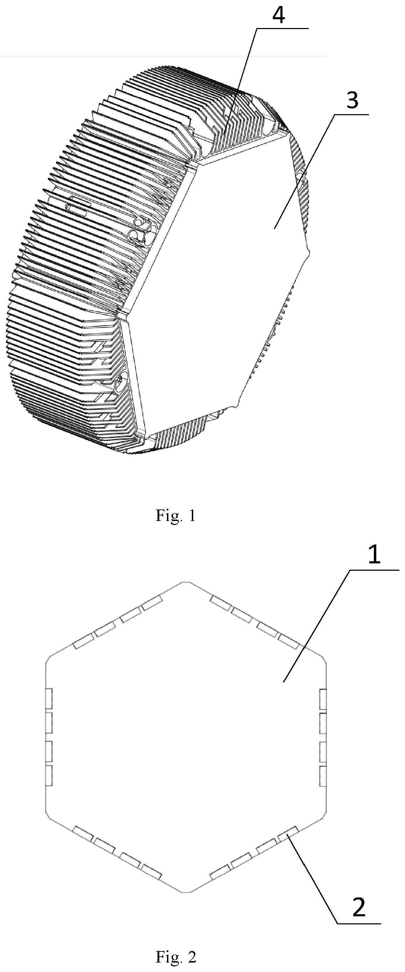

Embodiments of the present invention are described below with reference to the accompanying drawings. As shown in Figures 1 and 2, the ESC module of the embodiments of the present invention comprises: a PCB 1, a plurality of transistors 2, and a module housing 3. The transistors 2 are arranged at intervals along an edge of the PCB 1, and the module housing 3 is fitted over the PCB 1. The sides of the transistors 2 facing the module housing 3 are connected to a ceramic substrate (not shown in the figures), which establishes thermal conduction with the inner wall of the module housing 3 to dissipate the heat generated by the transistors 2.

Specifically, the transistors 2 are arranged at intervals along the edges of the PCB 1 (Printed Circuit Board) to reduce heat accumulation in the center of the power board. This allows the motor corresponding to the ESC module to be assembled closer to the center of the power board, reducing overall assembly difficulty and volume. Preferably, the transistors 2 are placed vertically on the edges of the PCB 1, with their heat dissipation surfaces perpendicular to the plane of the PCB 1. This heat dissipation surface is the side facing the module housing 3, which may be the side where the wafer of the transistor 2 (as a power semiconductor) is located, the side where the metal heat dissipation surface of the encapsulated IGBT 2 is located, or the side with the largest surface area of the transistor 2, etc., and the heat dissipation surface faces the outer periphery of the PCB 1. Furthermore, the ceramic substrate is partially coated with a copper foil, and the heat dissipation surfaces of the transistors 2 are soldered to the copper-coated portions of the ceramic substrate. This achieves thermal conduction between the heat dissipation surfaces of the transistors 2 and the copper-coated portions of the ceramic substrate without the need for thermal grease, thereby reducing costs. The embodiments of the present invention utilize the ceramic substrate to dissipate heat generated by the power devices while exploiting the insulating properties of the ceramic substrate to provide electrical insulation between the power devices and the module housing.

Furthermore, a thermal grease can be applied between the ceramic substrate and to the inner wall of the module housing 3 to enhance heat dissipation efficiency. Further, the PCB 1 features a regular hexagonal structure, and the transistors 2 are arranged in central symmetry with the center of the PCB 1 as the origin. The ESC module comprises a plurality of heat sinks 4, and the module housing 3 also has a regular hexagonal structure. The module housing 3 encloses the PCB 1, and the outer side of the module housing 3 is surrounded by the plurality of heat sinks 4, whose outer edges form a circular structure to match the circular structure of the motor. Designing the PCB 1 as a regular hexagonal structure effectively reduces the weight of the heat dissipation housing, facilitating the lightweight design of the power system. In this embodiment, the transistors 2 are divided into six groups with identical structures. Using the center of the PCB 1 as the origin, they are evenly distributed along the six edges of the PCB 1 in a fan-shaped arrangement with 60° between adjacent groups. This forms an overall centrally symmetric layout for the transistors 2, which ensures that the current loop impedance of the ESC module's three phases remains consistent.

The thickness of the ceramic substrate is at least 0.9 mm to ensure optimal insulation. Preferably, Silicon Carbide (SiC) MOSFETs are used for the transistors 2. Compared to ordinary transistors, SiC MOSFETs offer superior voltage resistance and thermal conductivity, as well as faster switching speeds and lower switching losses, which can increase the switching frequency and reduce motor heat generation. Utilizing SiC MOSFETs allows for the selection of a higher voltage platform. At the same power level, this reduces both the busbar current and the three-phase current, subsequently decreasing the weight of the corresponding wiring harness. Furthermore, the increased voltage can also accelerate charging speeds.

Furthermore, each transistor 2 comprises a pair of high-voltage pins. The edge of the PCB 1 is provided with a plurality of gaps each forming an air slot, and each pair of high-voltage pins is soldered to both sides of a gap. The center-to-center distance between two high-voltage pins is 5.04 mm. However, because connection pads must be provided on the PCB 1, the actual creepage distance is only 2.5 mm. By implementing the air slot, a creepage distance of over 4 mm can be achieved under the IP67 protection rating of the controller.

The embodiments of the present invention further provide a power unit, which comprises a motor module and the ESC module described in the aforementioned embodiments. The ESC module of the power unit in the present invention utilizes a ceramic substrate to dissipate the heat generated by the power devices, improving heat dissipation efficiency while providing electrical insulation between the power devices and the module housing.

The above embodiments are only illustrative of the principles and effects of the present invention. Anyone skilled in the art may modify or change the above embodiments without departing from the purpose of the present invention. Therefore, all equivalent modifications or changes made by those skilled in the art without departing from the disclosed purpose of the present invention shall fall within the scope of the claims of the present invention.

## Claims

1. An electronic speed controller (ESC) module, comprising: a PCB (1); a plurality of transistors (2) arranged at intervals along an edge of the PCB (1); a module housing (3) fitted over the PCB (1), wherein a side of each transistor (2) facing the module housing (3) is connected to a ceramic substrate, and the ceramic substrate establishes thermal conduction with an inner wall of the module housing (3) to dissipate heat generated by the transistors (2).

2. The ESC module according to claim 1, wherein a thermal grease is applied between the ceramic substrate and the inner wall of the module housing (3).

3. The ESC module according to claim 1, wherein the transistors (2) are placed vertically on the edge of the PCB (1) and heat dissipation surfaces of the transistors (2) are perpendicular to the plane of the PCB (1).

4. The ESC module according to claim 1, wherein the ceramic substrate is partially coated with a copper foil, and heat dissipation surfaces of the transistors (2) are soldered to the copper-coated portions of the ceramic substrate.

5. The ESC module according to claim 1, wherein the PCB (1) has a regular hexagonal structure, and the transistors (2) are arranged in central symmetry with the center of the PCB (1) as the origin.

6. The ESC module according to claim 5, further comprising a plurality of heat sinks (4), wherein the module housing (3) has a regular hexagonal structure and encloses the PCB (1), an outer side of the module housing (3) is surrounded by the plurality of heat sinks, and the outer edges of the plurality of heat sinks form a circular structure.

7. The ESC module according to claim 1, wherein a thickness of the ceramic substrate is at least 0.9 mm.

8. The ESC module according to claim 1, wherein the transistors (2) are Silicon Carbide (SiC) MOSFETs.

9. The ESC module according to claim 1, wherein each transistor (2) comprises a pair of high-voltage pins, the edge of the PCB (1) is provided with a plurality of gaps each forming an air slot, and each pair of high-voltage pins is soldered to both sides of a gap.

10. A power unit, comprising a motor module and the ESC module according to any one of claims 1 to 9.
